Europäisches Patentamt

European Patent Office

Office européen des brevets

(19)

(11) Veröffentlichungsnummer: **0 350 816**
**A2**

(12) **EUROPÄISCHE PATENTANMELDUNG**

(21) Anmeldenummer: **89112519.7**

(22) Anmeldetag: **08.07.89**

(51) Int. Cl.⁴: **H01L 29/91**

Die Bezeichnung der Erfindung wurde geändert (Richtlinien für die Prüfung im EPA, A-III, 7.3).

(30) Priorität: **14.07.88 DE 3823795**

(43) Veröffentlichungstag der Anmeldung:
**17.01.90 Patentblatt 90/03**

(84) Benannte Vertragsstaaten:
**CH FR GB IT LI SE**

(71) Anmelder: **SEMIKRON Elektronik GmbH**
**Sigmundstrasse 200**
**D-8500 Nürnberg 82(DE)**

(72) Erfinder: **Lutz, Josef**
**Knauerstrasse 11**
**D-8500 Nürnberg(DE)**
Erfinder: **Vollertsen, Gisela**
**Leipziger Strasse 16c**
**D-8520 Erlangen(DE)**

(54) **Schnelle Leistungsdiode und Verfahren zu ihrer Herstellung.**

(57) Schnelle Leistungsdiode und Verfahren zu ihrer Herstellung.

Das Recovery-Verhalten schneller Leistungsdioden mit psn-Struktur ist im wesentlichen durch Dotierung und Bemessung der hochohmigen Mittelzone bestimmt. Solche Dioden erfüllen jedoch nicht alle Anforderungen an einen Betrieb in Verbindung mit schaltbaren Halbleiterbauelementen.

Die schnelle Diode nach der Erfindung weist durch veränderte Ausbildung der $p^+$-Emitterzone ein optimiertes Recovery-Verhalten auf und ist auch unter erhöhten Anforderungen in unterschiedlichen Schaltungen der Leistungselektronik als Freilaufdiode anwendbar. Das neue Verfahren ermöglicht mit bekannten Schritten in einfacher Weise das Herstellen einer psn-Struktur mit gewünschtem Recovery-Verhalten.

Bei der neuen Diode ist die $p^+$-Emitterzone erheblich dünner ausgebildet, und ihre Dotierungskonzentration beträgt $10^{17}$ bis $5 \times 10^{18}$ Atome/cm⁻³, $10^3$ bis $10^4$ Atome/cm⁻³ weniger als die der $n^+$-leitenden Außenzone. Letztere ist noch mit einer $n^{++}$-leitenden Oberflächenzone versehen. Verfahrensgemäß werden zunächst an der Mittelzone die $n^+$-leitende Zone und die $p^+$-Emitterzone erzeugt, danach wird die $n^{++}$-Oberflächenzone ausgebildet, und Schwermetallatome werden p-emitterseitig eingebracht.

Fig.2a

Die Erfindung betrifft eine schnelle Leistungsdiode mit den Merkmalen nach dem Oberbegriff
des Anspruchs 1 sowie ein Verfahren zum Herstellen einer solchen Diode.

In Schaltkreisen mit induktiver Last ist antiparallel zum schaltenden Bauelement oder zur entsprechenden Bauelementeschaltung eine sogenannte Freilaufdiode angeordnet. Mit der Qualität
der schaltenden Bauelemente wachsen auch die
Anforderungen an die Freilaufdioden. Neben einer
Sperrspannungsbelastbarkeit von z.B. größer als
1200 V, einem niedrigen Durchlaßspannungsabfall
und geringem Rückstrom wird ein weiches sogenanntes Recovery-Verhalten gefordert, eine dem
dynamischen Verhalten der Diode zugeordnete Eigenschaft, welche das Ausräumen eines Plasmas
von Ladungsträgern aus dem Halbleiterkörper beim
Umschalten aus der Durchlaßphase in die Sperrphase betrifft. Bei weichem Recovery-Verhalten
klingt der Rückstrom im wesentlichen sanft ab,
ohne daß durch ihn unerwünschte Überspannungen
in der Schaltung entstehen. Kenngröße für dieses
Verhalten ist der sogenannte Weichheitsfaktor w.

Bei bekannten Bauformen von schnellen Leistungsdioden wird das Recovery-Verhalten durch
Dotierung und Bemessung der hochohmigen Mittelzone der Dreischichtenstruktur des Halbleiterkörpers beeinflußt. Je nach Vorgabe der Sperrspannungsbelastbarkeit kann die maximale Störstellenkonzentration z.B. $2 \times 10^{14} \text{cm}^{-3}$ für 1000 V und
$7 \times 10^{13} \text{cm}^{-3}$ für 2000 V betragen mit einer zugeordneten Mindestdicke der Mittelzone von 80 $\mu$m bzw.
180 $\mu$m . Das Recovery-Verhalten kann jedoch, wie
Untersuchungen gezeigt haben, allein durch Bemessung der WEite der mittleren Zone mittels Vorgabe von Dotierungskonzentration und Sperrfähigkeit nicht. in gewünschter Weise optimiert werden,
und die Anforderungen an den Weichheitsfaktor w
in Abhängigkeit vom Anwendungsfall und vom Einsatz der heute angebotenen, schaltbaren Halbleiterbauelemente sind mit einer solchen Bemessung
der Leistungsdioden nicht erfüllbar.

Weiter ist es bekannt, zur lokalen
Trägerlebensdauer-Einstellung und damit zur Beeinflussung des Schaltverhaltens im Sinne einer
Veränderung des Recovery-Verhaltens eine Protonenbestrahlung und Bestrahlung mit Heliumkernen
anzuwenden. Infolge des erheblichen Aufwandes
an Apparaturen und Verfahrenszeit ist diese Methode für die Serienfertigung von schnellen Leistungsdioden derzeit nicht verfügbar.

Der Erfindung liegt die Aufgabe zugrunde,
schnelle Leistungsdioden anzugeben, die mit optimiertem Recovery-Verhalten alle erhöhten Anforderungen beim Einsatz als Freilaufdioden in den unterschiedlichen Schaltungen der Leistungselektronik erfüllen.

Die Lösung der Aufgabe besteht bei einer Leistungsdiode der eingangs genannten Art in den
kennzeichnenden Merkmalen des Anspruchs 1 sowie beim Verfahren zum Herstellen einer solchen
Diode in den kennzeichnenden Merkmalen des Anspruchs 6. Vorteilhafte Ausgestaltungen sind in den
Unteransprüchen 2 bis 5 und 7 bis 9 angegeben.

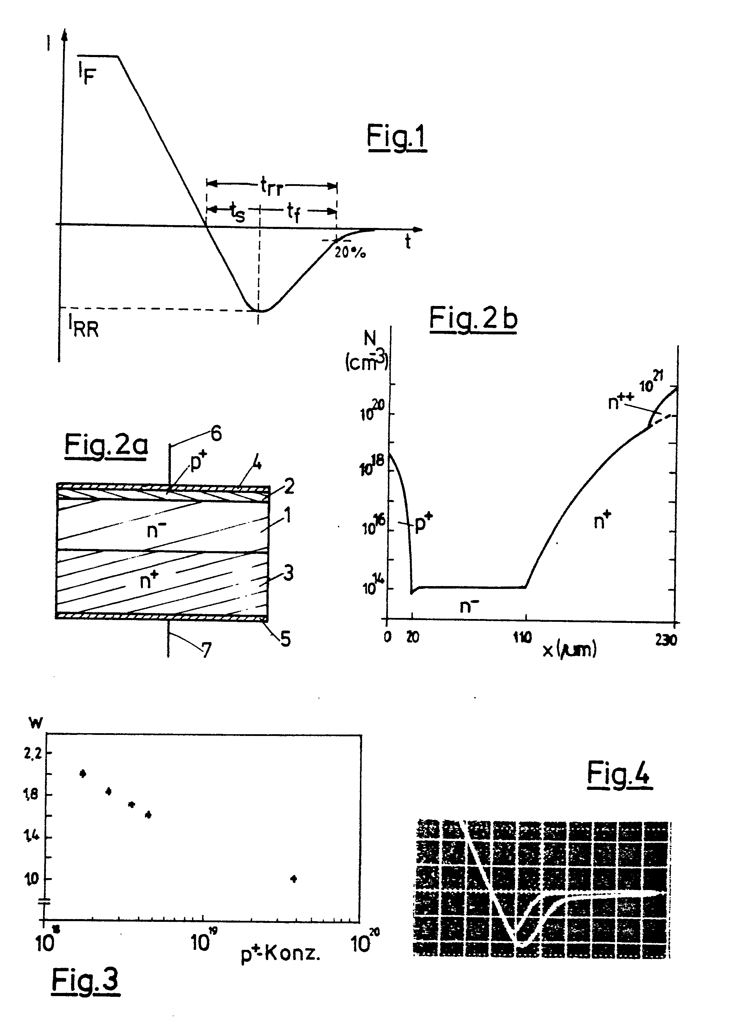

Anhand der in den Figuren gezeigten Ausführungsbeispiele und Schaubilder wird die Erfindung
erläutert. Figur 1 zeigt den Stromverlauf beim Umschalten der schnellen Diode von der Durchlaßphase in die Sperrphase für die Definition des Weichheitsfaktors w. Figur 2a zeigt schematisch die
Schichtenstruktur, Figur 2b das zugehörige Dotierungsprofil. In Figur 3 ist der Zusammenhang zwischen dem Weichheitsfaktor w und der Störstellenkonzentration der zweiten Außenzone und im Oszillogramm der Figur 4 ist der Rückstromverlauf bei
unterschiedlicher Verfahrenstemperatur der Diffusion von Platinatomen dargestellt.

Gemäß Figur 1 nimmt der Durchlaßstrom $I_f$
schaltungsbedingt bis auf O ab, und infolge noch
vorhandener Ladungen im Schichtenaufbau der
Freilaufdiode nach dem Umschalten aus der
Durchlaß- in die Sperrphase fließt ein Rückstrom
$I_{RR}$ und fällt im Verlauf der Sperrphase ab. Die Zeit
zwischen Strom-O-Durchgang und Rückstrommaximum ist die Spannungsnachlaufzeit $t_s$. Diese wird
wegen der schaltungsbedingten Abkommutierungsgeschwindigkeit -di/dt vom Rückstromverlauf beeinflußt und bestimmt dadurch mit das Recovery-
Verhalten. Ein bei bekannten Freilaufdioden durch
Weite und Dotierung der Mittelzone festgelegtes
Recovery-Verhalten führt zu sehr schnellem Abfall
des Rückstromes mit der Folge unerwünscht hoher
Überspannung. Es wird daher zur Vermeidung einer Beschädigung oder Zerstörung von Bauelementen der jeweiligen Schaltung ein sanftes Abklingen des Rückstromes angestrebt, das heißt ein
Ausräumen der Restladung aus dem Halbleiterkörper, ohne daß unzulässige Überspannungen entstehen. Die Zeit zwischen Rückstrommaximum und
Reduzierung des Rückstomes auf 20% ist die sogenannte Rückstromfallzeit $t_f$. Der Quotient aus
Rückstromfallzeit $t_f$ und Spannungsnachlaufzeit $t_s$
ist der Weichheitsfaktor w, die Summe beider Zeiten ist die Sperrverzugszeit $t_{RR}$.

Erfindungsgemäße Maßnahmen zur Erzielung
des gewünschten Rückstromverlaufs betreffen die
Trägerlebensdauer im Bereich des pn-Übergangs
und die Störstellenkonzentration $N_A$ der den Emitter am pn-Übergang bildenden Außenzone (3). Untersuchungen haben gezeigt, daß eine Reduzierung
von $N_A$ das RecoveryVerhalten in der gewünschten
Weise beeinflußt. Die in Figur 2a dargestellte
Schichtenfolge besteht aus einer hochohmigen, n-
leitenden Mittelzone (1), einer an der einen Seite
der Mittelzone angrenzenden, hochdotierten Außenzone (2) vom gleichen Leitungstyp und einer an der anderen Seite angrenzenden, hochdotierten, p-leitenden Außenzone (3), welche den $p^+$-Emitter bildet. Mit (4) und (5) sind Kontaktelektroden der beiden Außenzonen (2) und (3), und mit (6) bzw. (7) sind die zugeordneten Anschlußleitungen bezeichnet. Bei bekannten Freilauf- oder schnellen Dioden ist der $p^+$-Emitter höchstdotiert, das heißt mit Störstellen in einer Konzentration von $10^{20}$ cm$^{-3}$ oder höher versehen. Vorliegend ist jedoch die Dotierung auf den Bereich $10^{17}$ bis $5 \times 10^{18}$ cm$^{-3}$ eingestellt, somit um drei bis vier Größenordnungen niedriger als bei bekannten Anordnungen. Die untere Grenze dieses Bereichs wird durch die Bedingung bestimmt, daß eine für gute Stoßstrombelastbarkeit bei unterschiedlichen Anwendungen ausreichende Injektion des p-Emitters erfolgen muß. Dadurch erhöht sich die Rückstromfallzeit $t_f$ bei gleichem Rückstrom $I_{RR}$, der Weichheitsfaktor w wird größer. Dies wird damit erklärt, daß bei geringerer p-Dotierung die Injektion aus dem $p^+$-Emitter (3) in die Mittelzone (1) geringer und damit die Überschwemmung der Zonenfolge mit Ladungsträgern aus dem $p^+$-Emitter während der Durchlaßphase niedriger ist. Beim Umschalten der Diode in die Sperrphase wird der pn-Übergang schneller von Ladungsträgern frei, während die Mittelzone (1) noch einen Ladungsträgerstau aufweist. Weiter ist durch die niedrigere Konzentration der p-Dotierung am pn-Übergang die Getterwirkung in Bezug auf die nachfolgende Schwermetalleinbringung geringer. Es bleiben mehr Rekombinationszentren in der Zonenfolge wirksam, sodaß gegenüber höchstdotiertem $p^+$-Emitter (3) die Trägerlebensdauer im pn-Bereich kleiner ist. Währenddessen ändert sich die Trägerlebensdauer im Bereich des $nn^+$-Überganges im wesentlichen nicht. Das Zusammenwirken der vorgenannten Maßnahmen führt zu einer Verminderung des Rückstromes $I_{RR}$, damit zu einer Verringerung der Spannungsnachlaufzeit $t_s$ und zu der angestrebten Erhöhung des Weichheitsfaktors w.

Aus dem in Figur 2b dargestellten Dotierungsprofil ist die stark unsymmetrische Dotierung der Diode nach der Erfindung deutlich erkennbar. Die Störstellenkonzentration der hochohmigen Mittelzone (1) ist gegenüber bekannten Bauformen nicht verändert und beträgt etwa $10^{14}$ cm$^{-3}$.

Für die zweite Außenzone (3) ist maximal eine Dicke von 40 μm vorgesehen; bevorzugt wird eine Dicke im Bereich von 10 μm bis 20 μm. Auch darin unterscheidet sich die Bauform nach der Erfindung wesentlich von bekannten Ausführungsbeispielen.

Die Dotierungskonzentration des $p^+$-Emitters (3) ist mittels Ionenimplantation oder mittels einer Borvorbelegung durch Feststoffquellen-Diffusion z.B. mit Bornitrid-Dotierscheiben als erstem Verfahrensschritt und mittels einer sogenannten Eintreib-Diffusion als zweitem Verfahrensschritt erzielbar. Es kann jedoch auch ein einstufiges Diffusionsverfahren mit Gallium als Dotierungsmaterial vorgesehen sein.

Die hochohmige Mittelzone (1) ist gegenüber bekannten Bauformen dünner ausgebildet. Damit wird einerseits ein niedriger Durchlaßspannungsabfall erreicht und die Verlustleistung im Halbleiterkörper bestmöglich reduziert. Andererseits ist für die angrenzende, höchstdotierte erste Außenzone (2), die gegenüber bekannten Anordnungen dicker ausgebildet ist, eine tiefe Diffusion vorgesehen, um einen hinreichend dicken Halbleiterkörper zu erhalten, welcher ohne zusätzlichen Trägerkörper bearbeitbar ist. Erfindungsgemäß wird weiterhin eine $n^{++}$-Diffusion in die hochdotierte erste Außenzone (2) durchgeführt, welche ebenfalls Getterwirkung hat und insbesondere eine Verlängerung der Rückstromfallzeit $t_f$ und damit eine Erhöhung des Weichheitsfaktors w bewirkt. Dieser Verfahrensschritt führt zu dem Ansatz am $n^+$-Bereich des Störstellenprofils nach Figur 2b und kann z.B. mit einer Phosphor-Diffusion hoher Konzentration erfolgen. Die Diskontinuität im Profilverlauf des $n^+$-Bereichs entsteht durch die Notwendigkeit, die Störstellenkonzentration der ersten äußeren Zone (2) in zwei getrennten und zeitlich aufeinanderfolgenden Prozessen zu erzeugen. Für die Phosphor-Diffusion wird vorzugsweise POCl$_3$ verwendet.

Aus Figur 3 ist die Abhängigkeit des Weichheitsfaktors w von der Dotierungskonzentration des $p^+$-Emitters (3) zu ersehen. Mit der Einstellung auf den Konzentrationsbereich gemäß der Erfindung ist eine erhebliche Verbesserung des Schaltverhaltens der Freilaufdioden erzielbar gegenüber bekannten Dioden mit Weichheitsfaktoren w kleiner 1,5.

Figur 4 betrifft den Einfluß von Schwermetallatomen auf das Schaltverhalten. Es ist bekannt, zur Reduzierung der Trägerlebensdauer Goldatome durch Diffusion in Halbleiterscheiben einzubringen. Diese Möglichkeit ist bei Dioden nach der Erfindung ebenfalls vorgesehen. Im Vergleich zu Gold kann jedoch mit Platin, das zur Erzeugung von Rekombinationszentren auch bekannt ist, ein um 20% höherer Weichheitsfaktor erzielt werden. Die Schwermetallatome werden vorzugsweise von der Seite des $p^+$-Emitters (3) aus in die Zonenfolge eingebracht. Die Diffusionszeit kann zwischen 10 und 45 Minuten liegen. Je nach den Anforderungen an das Bauelement kann die Temperatur für die Diffusion der Schwermetallatome und für die Verwendung von Platin im Bereich von 850°C bis 1000°C liegen. Die beiden Kurven des Oszillogramms der Figur 4 zeigen den Rückstromverlauf bei Verwendung von Platin und bei um 10°C unterschiedlicher Diffusionstemperatur. Aus den Oszillogrammen ist deutlich zu erkennen, daß eine Temperaturerhöhung zu einer Verringerung des Rückstromes $I_{RR}$ führt, wodurch die Spannungsnachlaufzeit vermindert und der Weichheitsfaktor w vergrößert wird.

**Ansprüche**

1. Schnelle Leistungsdiode mit einem Halbleiterkörper, der
- eine Folge von drei schichtförmigen Zonen aufweist, von welchen die hochohmige, mittlere Zone (1) vom ersten Leitungstyp
- an der einen Seite mit einer hochdotierten, ersten Außenzone (2) vom ersten Leitungstyp verbunden ist und
- an der anderen Seite mit einer hochdotierten, zweiten Außenzone (3) vom zweiten Leitungstyp einen pn-Übergang einschließt sowie mit
- Rekombinationszentren zur Verringerung der Trägerlebensdauer versehen ist, und
- bei dem die mittlere Zone (1) eine durch Wahl der Sperrspannungsbelastbarkeit bestimmte Dicke und Dotierungskonzentration aufweist, **dadurch gekennzeichnet, daß**
- die erste Außenzone (2) um den Faktor $10^3$ bis $10^4$ höher dotiert ist als die zweite Außenzone (3) und
- die Dotierungskonzentration der zweiten Außenzone $10^{17}$ bis $5 \times 10^{18}$ cm$^{-3}$ beträgt.

2. Schnelle Leistungsdiode nach Anspruch 1, dadurch gekennzeichnet, daß die Dicke der zweiten Außenzone (3) maximal 40 $\mu$m beträgt.

3. Schnelle Leistungsdiode nach Anspruch 2, dadurch gekennzeichnet, daß eine zweite Außenzone (3) mit einer Dicke im Bereich von 10$\mu$m bis 20$\mu$m vorgesehen ist.

4. Schnelle Leistungsdiode nach Anspruch 1, gekennzeichnet durch Rekombinationszentren, die mittels Diffusion von Schwermetallatomen gebildet sind.

5. Schnelle Leistungsdiode nach Anspruch 4, dadurch gekennzeichnet, daß Gold oder Platin zur Ausbildung von Rekombinationszentren vorgesehen sind.

6. Verfahren zum Herstellen einer Leistungsdiode nach den Ansprüchen 1 bis 5, bei dem in einem Halbleiterkörper mit einer Grunddotierung des ersten Leitungstyps an der einen seiner beiden einander gegenüberliegenden Seiten eine erste hochdotierte, äußere Zone (2) vom ersten Leitungstyp und an seiner anderen Seite eine zweite höher dotierte, äußere Zone (3) vom zweiten Leitungstyp ausgebildet wird, die mit der zwischen den äußeren Zonen liegenden, hochohmigen Mittelzone (1) einen pn-Übergang bildet, und bei dem in die Zonenfolge Schwermetallatome zur Verringerung der Trägerlebensdauer eingebracht werden, dadurch gekennzeichnet, daß

- eine erste, äußere Zone (2) mit einer Störstellenkonzentration von $10^{20}$ cm$^{-3}$ oder höher erzeugt wird,
- eine zweite, äußere Zone (3) mit einer Störstellenkonzentration von $10^{17}$ bis $5 \times 10^{18}$ cm$^{-3}$ erzeugt wird, und
- anschließend in der ersten äußeren Zone durch einen getrennten Verfahrensschritt eine Oberflächenkonzentration höher als die Konzentration der ersten Zone (2) hergestellt wird.

7. Verfahren nach Anspruch 6, dadurch gekennzeichnet, daß die zweite äußere Zone (3) mittels einer Vorbelegung durch Feststoffquellendiffusion und einer anschließenden Eintreibdiffusion hergestellt wird.

8. Verfahren nach Anspruch 6, dadurch gekennzeichnet, daß die zweite äußere Zone (3) mit einer Dicke von bis zu 40 $\mu$m hergestellt wird.

9. Verfahren nach Anspruch 6, dadurch gekennzeichnet, daß die Schwermetallatome von der Seite der zweiten äußeren Zone (3) aus eingebracht werden.

Fig.1

$t_{rr}$

$t_s$  $t_f$

$I_F$

$I_{RR}$

20%

t

I

Fig.2b

Fig.2a

6

$p^+$

4

2

$n^-$

1

$n^+$

3

5

7

N
(cm$^{-3}$)

$10^{21}$

$n^{++}$

$10^{20}$

$10^{18}$

$10^{16}$

$p^+$

$n^+$

$10^{14}$

$n^-$

0   20        110           230   x($\mu$m)

w

2,2

1,8

1,4

1,0

$10^{18}$        $10^{19}$    $p^+$-Konz.    $10^{20}$

Fig.3

Fig.4